(19) Europäisches Patentamt / European Patent Office / Office européen des brevets

(11) **EP 2 833 379 A1**

(12) **DEMANDE DE BREVET EUROPEEN**

(43) Date de publication:
**04.02.2015 Bulletin 2015/06**

(51) Int Cl.:
*H01F 27/42* (2006.01)   *H03F 3/45* (2006.01)
*H03H 11/12* (2006.01)   *H04B 3/14* (2006.01)
*G01R 15/18* (2006.01)

(21) Numéro de dépôt: **14178868.7**

(22) Date de dépôt: **29.07.2014**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(30) Priorité: **31.07.2013  FR 1357603**

(71) Demandeur: **Schneider Electric Industries SAS
92500 Rueil-Malmaison (FR)**

(72) Inventeur: **Guenego, Michel
38050 Grenoble Cedex 9 (FR)**

(74) Mandataire: **Brevalex
95, rue d'Amsterdam
75378 Paris Cedex 8 (FR)**

(54)   **Correction de la bande passante d'un transformateur à entrefer**

(57)   Dispositif de correction de la bande passante d'un transformateur à entrefer (modelisé par 100+101+102+104), présentant une fréquence de coupure, caractérisé en ce qu'il comporte un filtre (201-207) destiné à être relié en série avec le transformateur, et en ce que le filtre est adapté pour amplifier le signal qu'il reçoit du transformateur pour des fréquences inférieures à la fréquence de coupure du transformateur, de sorte que la bande passante du transformateur équipé du dispositif de correction est augmentée et présente une fréquence de coupure inférieure à celle du transformateur.

FIG. 3

EP 2 833 379 A1

**Description**

**DOMAINE TECHNIQUE**

La présente invention concerne de manière générale les transformateurs électriques, et plus particulièrement les transformateurs à entrefers, tels que ceux utilisés notamment pour faire des mesures de courant dans une installation électrique.

**ÉTAT DE LA TECHNIQUE ANTÉRIEURE**

Si l'on considère une ligne électrique équipée d'un disjoncteur, un courant transitoire se superpose au courant nominal à la fermeture du disjoncteur. Ce courant transitoire a une intensité élevée relativement au courant nominal.

Le niveau du courant transitoire doit être pris en compte pour dimensionner un transformateur de mesure équipant cette ligne électrique.

En effet, un transformateur présente un noyau de fer et a pour caractéristique de saturer à partir d'un niveau donné de courant le traversant. Le transformateur doit donc être dimensionné pour éviter la saturation pour un courant transitoire attendu.

D'autre part, une bobine de Rogowski est un dispositif permettant la mesure de courant alternatif qui ne présente pas de noyau de fer. Le phénomène de saturation est évité, mais une bobine de Rogowski est sensible aux perturbations électromagnétiques et ce type de dispositif n'est pas utilisé en pratique dans les installations de moyenne ou haute tension.

En pratique, les transformateurs de mesure sont des transformateurs sans entrefer ou avec un entrefer minimal. La présence d'un entrefer repousse la saturation à un niveau plus élevé. En d'autres termes, le courant pour lequel apparait la saturation est plus élevé dans un transformateur à entrefer que dans un transformateur de même dimensionnement mais sans entrefer.

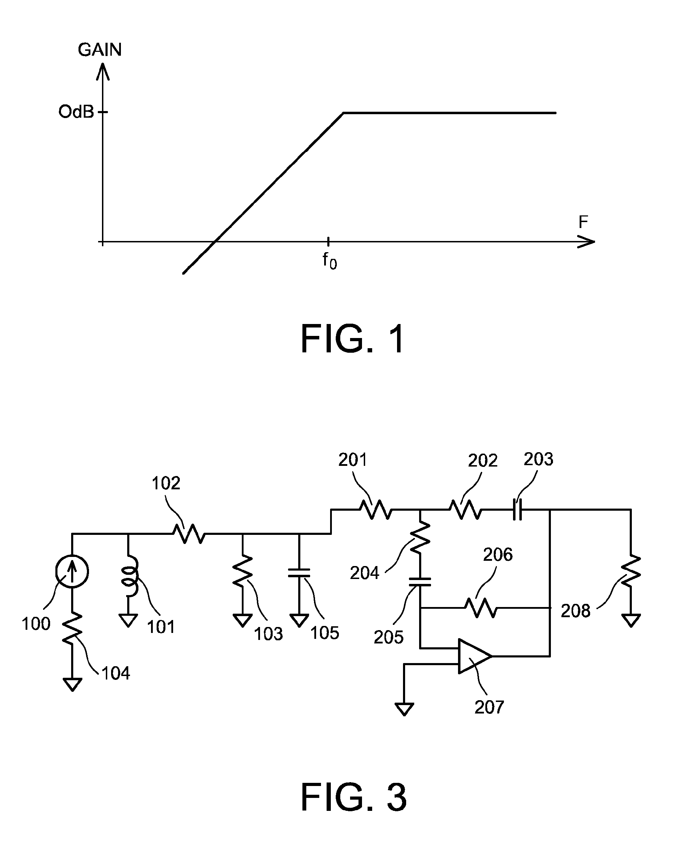

Cependant, un transformateur à entrefer a une fonction de transfert qui peut être modélisée par celle d'un filtre passe-haut du premier ordre. Comme représenté à la **figure 1,** la fonction de transfert est une droite croissante en dessous d'une fréquence de coupure fo puis présente un gain constant au-dessus de la fréquence de coupure. Plus l'entrefer est important, plus la fréquence de coupure est élevée.

Ainsi, les fréquences inférieures à la fréquence de coupure sont atténuées et déphasées. En d'autres termes, ce filtrage passe-haut, ou dérivateur, élimine la composante continue du signal. Ce filtrage est une conséquence non souhaitée de la présence de l'entrefer qui a pour but de réduire le phénomène de saturation et donc le dimensionnement du transformateur à performances données. Il y a donc un compromis à trouver entre performances, dimensionnement, saturation et filtrage. Le besoin de précision empêche dans la pratique l'utilisation d'un entrefer significatif.

**EXPOSÉ DE L'INVENTION**

L'invention vise à résoudre les problèmes de la technique antérieure en fournissant un dispositif de correction de la bande passante d'un transformateur à entrefer, présentant une fréquence de coupure, caractérisé en ce qu'il comporte un filtre destiné à être relié en série avec le transformateur, et en ce que le filtre est adapté pour amplifier le signal qu'il reçoit du transformateur pour des fréquences inférieures à la fréquence de coupure du transformateur, de sorte que la bande passante du transformateur équipé du dispositif de correction est augmentée et présente une fréquence de coupure inférieure à celle du transformateur.

La bande passante du transformateur à entrefer équipé du dispositif de correction est ainsi similaire à celle d'un transformateur sans entrefer ou avec un entrefer plus petit. Grâce à l'invention, il est possible de concevoir des transformateurs à entrefer pour lesquels le problème de filtrage en basse fréquence est réduit ou supprimé, ce qui simplifie la question du compromis à trouver entre performances, dimensionnement et saturation.

A performances données, il est par exemple possible de concevoir un transformateur plus petit, moins lourd, moins cher, tout en présentant de bonnes capacités à ne pas saturer en cas de courant transitoire.

Il est à noter que le transformateur à entrefer équipé du dispositif de correction selon l'invention est beaucoup moins sensible à des perturbations électromagnétiques qu'une bobine de Rogowski.

Le dispositif de correction peut être implémenté dans le transformateur à entrefer, ou dans un relais de protection, ou encore dans une chaîne de traitement numérique.

Le dispositif de correction agit comme un réducteur d'entrefer, tout en conservant les bénéfices de celui-ci.

Selon une caractéristique préférée, le filtre est un filtre du premier ordre dont la fréquence de coupure est égale à celle du transformateur.

Selon une autre caractéristique préférée, le filtre est un filtre d'ordre supérieur ou égal à deux comportant une fréquence de coupure inférieure à celle du transformateur, adapté pour agir comme un filtre dérivateur pour des fréquences inférieures à la fréquence de coupure du filtre, comme un filtre intégrateur pour des fréquences comprises entre la fréquence de coupure du filtre et celle du transformateur et ayant un gain constant pour des fréquences supérieures à la fréquence de coupure du transformateur.

Selon une caractéristique préférée, le dispositif de correction est implémenté de manière analogique.

Selon une caractéristique préférée alternative, le dispositif de correction est implémenté de manière numérique.

L'invention concerne aussi un transformateur à entrefer équipé d'un dispositif tel que précédemment présenté.

L'invention concerne aussi un relais de protection équipé d'un dispositif tel que précédemment présenté et adapté pour être relié en aval d'un transformateur à entrefer.

L'invention concerne aussi un procédé de correction de la bande passante d'un transformateur à entrefer, présentant une fréquence de coupure, caractérisé en ce qu'il comporte des étapes de :

- mesure de valeurs d'un signal de courant en sortie du transformateur à entrefer,
- application d'un filtrage aux valeurs mesurées qui amplifie le signal de courant pour des fréquences inférieures à la fréquence de coupure du transformateur, de sorte que la bande passante du transformateur équipé du dispositif de correction est augmentée et présente une fréquence de coupure inférieure à celle du transformateur.

Le transformateur à entrefer, le relais de protection et le procédé présente des avantages analogues à ceux précédemment présentés.

Dans un mode particulier de réalisation, les étapes du procédé selon l'invention sont mises en oeuvre par des instructions de programme d'ordinateur.

En conséquence, l'invention vise aussi un programme d'ordinateur sur un support d'informations, ce programme étant susceptible d'être mis en oeuvre dans un ordinateur, ce programme comportant des instructions adaptées à la mise en oeuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur adaptées à la mise en oeuvre des étapes d'un procédé tel que décrit ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

## BRÈVE DESCRIPTION DES DESSINS

D'autres caractéristiques et avantages apparaîtront à la lecture d'un mode de réalisation préféré donné à titre d'exemple non limitatif, décrit en référence aux figures dans lesquelles :

- La figure 1 représente la fonction de transfert d'un transformateur à entrefer,
- La figure 2a représente un exemple de mise en oeuvre de l'invention,
- La figure 2b représente un autre exemple de mise en oeuvre de l'invention,
- La figure 3 représente un circuit électrique modélisant un transformateur à entrefer équipé d'un dispositif de correction selon l'invention,
- La figure 4a représente le diagramme de Bode du transformateur à entrefer sans le dispositif de correction,
- La figure 4b représente le diagramme de Bode du dispositif de correction,
- La figure 4c représente le diagramme de Bode du transformateur à entrefer avec le dispositif de correction,
- La figure 5 représente la réponse temporelle du transformateur à entrefer, avec et sans le dispositif de correction,
- La figure 6 représente un mode de réalisation du dispositif selon l'invention, et
- La figure 7 représente un mode de réalisation de procédé de correction de la bande passante d'un transformateur à entrefer, selon l'invention.

## EXPOSÉ DÉTAILLÉ DE MODES DE RÉALISATION PARTICULIERS

La figure 1 a déjà été commentée dans le préambule et ne sera pas à nouveau commentée ici.

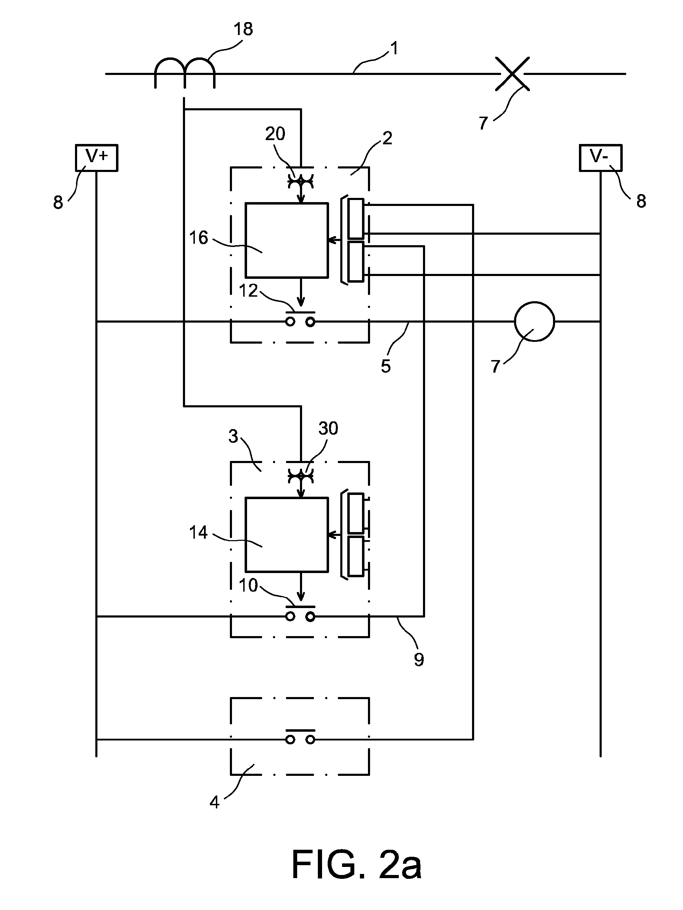

Selon un exemple de mise en oeuvre de l'invention décrit en référence à la **figure 2a,** une section de ligne électrique 1 est protégée par un système de protection qui comporte des relais de protection 2 et 3 et un équipement de surveillance et de commande externe 4.

Les relais de protection 2 et 3 sont connectés à la ligne 1 par le biais d'un transformateur 18, de manière à acquérir des informations analogiques sur l'état de la ligne.

Le circuit secondaire du transformateur 18 est relié aux circuits primaires de transformateurs 20 et 30 qui sont des transformateurs à entrefer. Le circuit secondaire du transformateur 20 délivre une information de courant au relais de protection 2 et plus précisément à un circuit de pilotage 16 inclus dans le relais 2. De manière similaire, le circuit secondaire du transformateur 30 délivre une information de courant au relais de protection 3 et plus précisément à un circuit de pilotage 14 inclus dans le relais 3. Ainsi l'acquisition du courant sur la ligne 1 est réalisée en deux étapes, par les transformateurs 18, 20 et 30. Chacun des transformateurs 20 et 30 reçoit un dispositif selon l'invention.

Le relais de protection 3 est utilisé pour modifier le fonctionnement du relais de protection 2. Pour cela, une sortie 9 du relais de protection 3 est reliée à une entrée d'un dispositif d'acquisition d'état 100, intégré ou associé au relais de protection 2.

Le système de protection est alimenté par une batterie 8 de manière à sécuriser l'alimentation du système de protection.

Une entrée du circuit de pilotage 14 du relais de protection 3 reçoit une information sur l'état de la ligne 1 via le transformateur 30. Une sortie du circuit de pilotage 14 est reliée à un contact 10. Le contact 10 est piloté par le circuit 14 pour que le dispositif d'acquisition d'état 100 du relais de protection 2 soit alimenté par la batterie 8 lorsque le contact 10 est fermé.

Le relais de protection 2 utilise l'information ainsi transmise par le relais 3 en conjonction avec les données fournies par son propre circuit de pilotage 16 pour déterminer une action à entreprendre. Une sortie du circuit de pilotage 16 est reliée à un contact 12 dont la sortie 5 est elle-même reliée à un circuit de déclenchement 6.

Le circuit de déclenchement 6 commande le fonctionnement d'un disjoncteur 7 connecté en série avec la ligne à protéger 1, pour en contrôler le courant.

L'équipement de surveillance et de commande externe 4 est un contact provenant d'un équipement extérieur, non représenté.

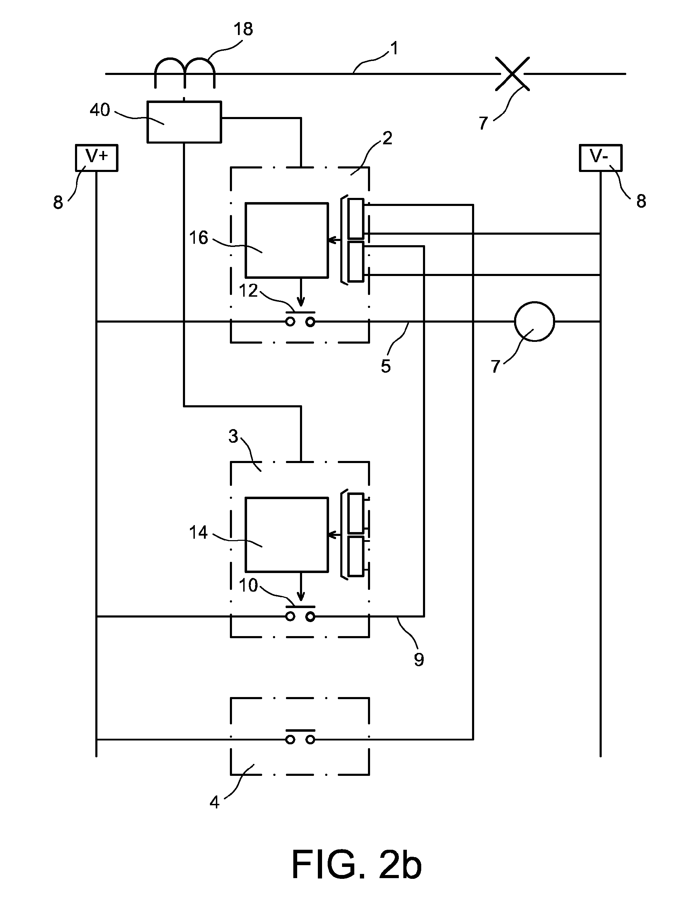

La **figure 2b** représente un autre exemple de mise en oeuvre de l'invention. Comme dans la figure 2a, une section de ligne électrique 1 est protégée par un système de protection qui comporte des relais de protection 2 et 3 et un équipement de surveillance et de commande externe 4. Par rapport à la figure 2a, les mêmes références numériques sont affectées aux éléments similaires. Seules les différences par rapport à la figure 2a sont décrites dans la suite.

Les relais de protection 2 et 3 sont connectés à la ligne 1 par le biais d'un transformateur 18, de manière à acquérir des informations analogiques sur l'état de la ligne. Dans cet exemple, le transformateur 18 est un transformateur à entrefer qui mesure le courant électrique sur la ligne 1. Le transformateur 18 reçoit un dispositif selon l'invention.

Le circuit secondaire du transformateur 18 est relié à une entrée d'un circuit de pilotage 40. Une sortie du circuit de pilotage 40 est reliée à chacun des relais de protection 2 et 3. Par rapport à la figure 2a, les relais de protection 2 et 3 ne comportent pas de transformateurs.

En référence à la **figure 3,** un transformateur à entrefer équipé d'un dispositif de correction de la bande passante selon l'invention est modélisé par un circuit électrique équivalent.

Pour modéliser le transformateur, le circuit électrique comporte essentiellement une source de courant 100, une inductance 101 et une résistance 102. La source de courant 100 représente un transformateur de courant parfait de rapport de transformation 1:1. L'inductance 101 modélise l'inductance de magnétisation vue du secondaire du transformateur. La résistance 102 représente la résistance interne du bobinage secondaire du transformateur.

Plus précisément, à partir d'une borne mise à la terre, le circuit comporte une résistance 104 reliée à une borne de la source de courant 100. La source de courant 100 a son autre borne reliée à une borne de l'inductance 101 et à une borne de la résistance 102. La résistance 104 permet de mesurer le courant injecté dans le transformateur.

L'autre borne de l'inductance 101 est reliée à la terre, et l'autre borne de la résistance 102 est reliée à une borne d'une résistance de mesure 103. L'autre borne de la résistance 103 est reliée à la terre.

Enfin un condensateur 105 est relié en parallèle de la résistance de mesure 103. Le condensateur 105 permet de limiter les hautes fréquences dues à d'éventuelles perturbations CEM.

Le dispositif de correction de bande-passante est modélisé par un filtre de premier ordre. Le filtre de correction comporte, à partir de la borne commune aux résistances 102 et 103, une résistance 201 dont l'autre borne est reliée à deux branches parallèles. La première branche comporte une résistance 202 en série avec un condensateur 203. La seconde branche comporte une résistance 204 reliée en série avec un condensateur 205 lui-même relié en série avec une résistance 206. Un amplificateur opérationnel 207 est relié en parallèle de la résistance 206. L'amplificateur opérationnel 207 a son entrée inverseuse reliée entre le condensateur 205 et la résistance 206 et son entrée non-inverseuse reliée à la terre. La sortie de l'amplificateur opérationnel 207 est reliée à la borne commune de la résistance 206 et du condensateur 203. Cette borne commune est enfin reliée à une borne d'une résistance 208 dont l'autre borne est reliée à la terre.

En variante, le dispositif de correction ne comporte pas les résistances 204 et 206 ni le condensateur 205. Il ne comporte alors que les résistances 201 et 202, le condensateur 203 et l'amplificateur 207.

La constante de temps du circuit équivalent du transformateur est L/R, où L est la valeur de l'inductance 101 et R est la résistance totale, soit la somme des résistances 102 et 103.

Le dispositif de correction est conçu de sorte que sa constante de temps soit égale à celle du transformateur. La constante de temps du dispositif de correction est donnée par le produit $R_cC_c$, où $R_c$ est la valeur de la résistance 201 et de la résistance 202 et $C_c$ est la valeur de la capacité du condensateur 203. En d'autres termes, la fréquence de coupure du filtre de correction est égale à celle du transformateur à entrefer.

On choisit les valeurs de $R_c$ et $C_c$ pour que soit vérifiée l'égalité suivante : $R_cC_c = L/R$. Il est à noter que la quantité L/R est facilement mesurable, puisque la fréquence de coupure du transformateur à entrefer est égale à $1/(2.\pi.L/R)$.

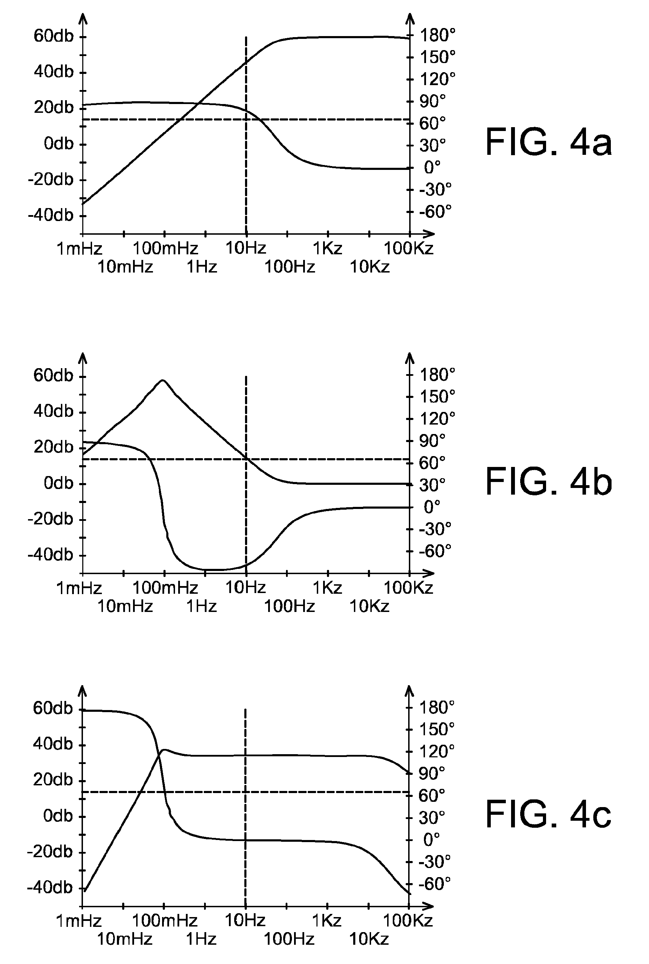

La **figure 4a** représente le diagramme de Bode du transformateur à entrefer sans le dispositif de correction.

La courbe de gain (échelle de gauche) est croissante jusqu'à la fréquence de coupure qui vaut environ 100 Hz dans l'exemple représenté, puis sensiblement en plateau ensuite. La courbe de phase (échelle de droite) montre l'existence d'un déphasage d'environ 90 degrés en dessous de 5 Hz, puis une diminution du déphasage qui devient nul au-delà de 1 KHz.

La **figure 4b** représente le diagramme de Bode du dispositif de correction.

La courbe de gain (échelle de gauche) est croissante jusqu'à la fréquence de coupure qui vaut environ 100 mHz dans l'exemple représenté, puis est décroissante jusqu'à 100 KHz environ, et enfin est constante au-delà. Le dispositif de correction joue ainsi le rôle d'un amplificateur dans une bande de fréquence qui est inférieure à la fréquence de coupure du transformateur à entrefer.

La courbe de phase (échelle de droite) montre l'existence d'un déphasage d'environ 90 degrés en dessous de 10 mHz, puis une diminution rapide du déphasage jusqu'à environ 1 Hz, une croissance jusqu'à environ 1 Khz et enfin un déphasage nul au-delà.

La **figure 4c** représente le diagramme de Bode du transformateur à entrefer équipé avec le dispositif de correction.

La courbe de gain (échelle de gauche) est croissante jusqu'à la fréquence de coupure qui vaut environ 100 mHz dans l'exemple représenté, puis présente un petit pic et devient ensuite sensiblement en plateau jusqu'à 10 kHz environ, et enfin est décroissante au-delà. On voit que la fréquence de coupure du transformateur à entrefer équipé du dispositif de correction est inférieure à celle du transformateur à entrefer sans le dispositif de correction.

La courbe de phase (échelle de droite) montre l'existence d'un déphasage d'environ 180 degrés en dessous de 10 mHz, puis une diminution rapide du déphasage qui devient nul au-delà de 1 Hz, puis qui décroit à nouveau au-delà de 1 Khz.

Ainsi, le transformateur à entrefer équipé du dispositif de correction présente un gain constant dans une plage de fréquence allant de 0,2 Hz à 10 kHz dans l'exemple représenté et un déphasage nul dans une plage de fréquence allant de 1 Hz à 1 kHz dans l'exemple représenté. La bande passante du transformateur a été augmentée pour être similaire à celle d'un transformateur avec un entrefer plus petit. Le déphasage du transformateur a été corrigé.

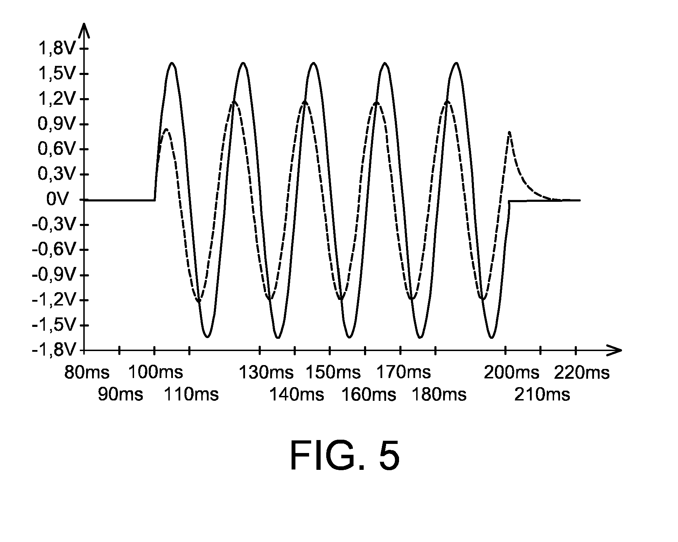

La **figure 5** représente la réponse temporelle du transformateur à entrefer, avec et sans le dispositif de correction.

La courbe en trait pointillé représente la tension mesurée aux bornes de la résistance 103, c'est-à-dire en sortie du transformateur. Cette tension est proportionnelle au courant de sortie du transformateur. La courbe en trait plein représente la tension d'entrée du transformateur, aux bornes de l'inductance 101.

A la mise sous tension (à 100 ms), le courant de sortie présente un régime transitoire pendant lequel l'amplitude du signal n'a pas encore atteint sa valeur nominale. De même, lorsque la tension redevient nulle en entrée du transformateur (à 200 ms), le courant de sortie présente un régime transitoire avant de devenir nul.

Le courant de sortie du transformateur est déphasé par rapport à la tension d'entrée.

La tension de sortie du dispositif de correction, mesurée aux bornes de la résistance 208, est superposée à la tension d'entrée. Grâce à la correction, il n'y a plus de régime transitoire ni de déphasage.

Selon un mode de réalisation préféré, on cherche en outre à ne pas amplifier les basses fréquences du signal, pour ne pas créer d'instabilité.

Dans ce cas, le filtre de correction est un filtre d'ordre 2. Il comporte un dérivateur, c'est-à-dire un filtre passe-haut, qui agit sur les basses fréquences. Plus précisément, comme le filtre de correction est essentiellement un filtre intégrateur, c'est-à-dire passe-bas, deux dérivateurs sont prévus : l'un pour compenser l'intégrateur, l'autre pour obtenir effectivement un dérivateur.

La pulsation de coupure $\omega_0$ entre le double dérivateur aux basses fréquences et l'intégrateur aux moyennes fréquences est inférieure à la pulsation de coupure du transformateur à entrefer qui vaut $(L/R)^{-1}$.

Dans le domaine de Laplace, la fonction de transfert du filtre de correction peut alors s'écrire :

$$H(s) = \frac{1}{\dfrac{L}{R}.\omega_0{}^2} . \frac{(1 + \dfrac{L}{R}.s).s}{1 + \dfrac{1}{Q}.\left(\dfrac{s}{\omega_0}\right) + \left(\dfrac{s}{\omega_0}\right)^2}$$

Dans cette formule, on note s l'opérateur de Laplace et Q un facteur de qualité.

En basses fréquences, c'est-à-dire pour une pulsation inférieure à la pulsation de coupure $\omega_0$ du filtre de correction, la fonction de transfert est sensiblement égale à :

$$H(s) = \frac{1}{\dfrac{L}{R}.\omega_0{}^2} . \frac{(1 + 0).s}{1 + \dfrac{1}{Q}.(0) + (0)^2} \approx \alpha.s$$

C'est la fonction de transfert d'un filtre passe-haut du premier ordre, à pente positive.

Entre la pulsation de coupure $\omega_0$ du filtre de correction et la pulsation de coupure du transformateur à entrefer $(2.\pi.L/R)^{-1}$, la fonction de transfert est sensiblement égale à :

$$H(s) = \frac{1}{\dfrac{L}{R}.\omega_0{}^2} . \frac{(1 + 0).s}{\left(\dfrac{s}{\omega_0}\right)^2} \approx \frac{\alpha}{s}$$

C'est la fonction de transfert d'un filtre passe-haut du premier ordre, à pente négative.

Au-dessus de la pulsation de coupure du transformateur à entrefer $(L/R)^{-1}$, la fonction de transfert est sensiblement égale à :

$$H(s) = \frac{1}{\dfrac{L}{R}.\omega_0{}^2} . \frac{(\dfrac{L}{R}.s).s}{\left(\dfrac{s}{\omega_0}\right)^2} \approx 1$$

Il s'agit donc d'une réponse en plateau. Le filtre de correction a alors un gain constant.

En variante, le filtre de correction peut être d'ordre supérieur à 2, en mettant en cascade des filtres d'ordre 1 et 2.

Le filtre de correction décrit est un filtre analogique. A partir de sa fonction de transfert H(s) exprimé dans le domaine de Laplace, on peut déterminer le filtre numérique H(z) en passant en transformée en Z.

De manière classique, on passe de la fonction de transfert analogique à son approximation numérique par la transformation d'Euler : $s = (1-z^{-1})/T$, ou par la transformation bilinéaire: $s = \dfrac{2}{T} . \dfrac{1 - z^{-1}}{1 + z^{-1}}$, dans lesquelles T est la période d'échantillonnage.

On en déduit un filtre à réponse impulsionnelle infinie de la forme :

$$y_n = \frac{1}{b_0} . \left( a_0.x_n + a_1.x_{n-1} + a_2.x_{n-2} - b_1.y_{n-1} - b_2.y_{n-2} \right)$$

Le filtre de correction numérique est mis en oeuvre par un circuit intégré dédié ou par des processeurs programmables, ou encore sous la forme d'un programme d'ordinateur mémorisé dans la mémoire d'un ordinateur.

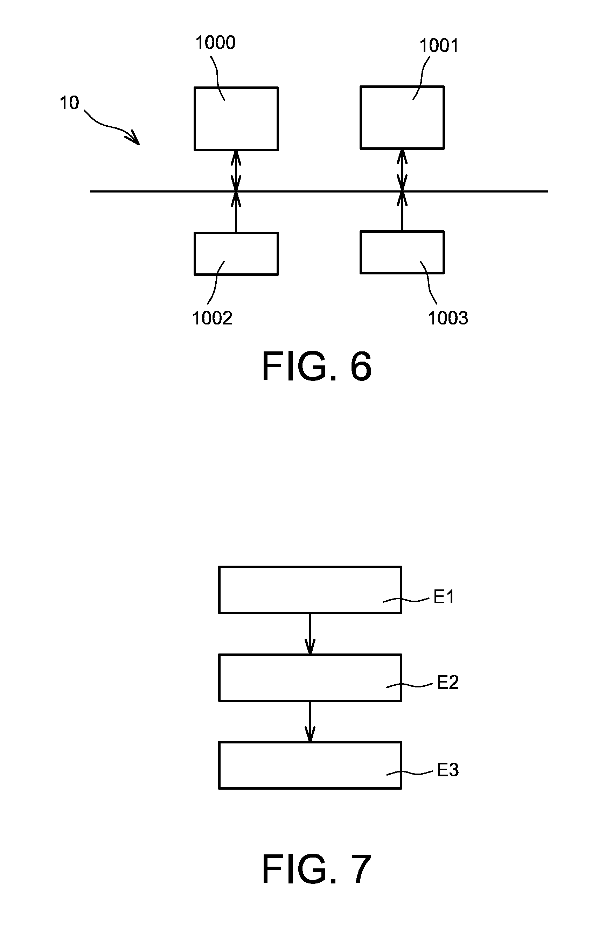

Ainsi, la **figure 6** représente un mode de réalisation particulier du dispositif selon l'invention.

Le dispositif 10 a la structure générale d'un ordinateur. Il comporte notamment un processeur 1000 exécutant un programme d'ordinateur mettant en oeuvre le procédé selon l'invention, une mémoire 1001, une interface d'entrée 1002 et une interface de sortie 1003.

Ces différents éléments sont classiquement reliés par un bus.

L'interface d'entrée 1002 est destinée à recevoir les valeurs de courant mesurées en sortie d'un transformateur à entrefer.

Le processeur 1000 exécute les traitements précédemment exposés. Ces traitements sont réalisés sous la forme d'instructions de code du programme d'ordinateur qui sont mémorisées par la mémoire 1001 avant d'être exécutées par le processeur 1000.

La mémoire 1001 peut en outre mémoriser les résultats des traitements effectués.

L'interface de sortie 1003 est reliée à un relais de protection.

En référence à la **figure 7,** le procédé de correction de la bande passante d'un transformateur à entrefer selon l'invention, mis en oeuvre par le dispositif précédemment décrit, comporte les étapes E1 à E3.

L'étape E1 est la mesure de valeurs d'un signal de courant en sortie du transformateur à entrefer.

L'étape suivante E2 est l'application d'un filtrage aux valeurs mesurées qui amplifie le signal de courant pour des fréquences inférieures à la fréquence de coupure du transformateur. Le résultat est un ensemble de valeurs filtrées.

L'étape suivante E3 est la fourniture des valeurs filtrées à un relais de protection.

## Revendications

1. Dispositif de correction de la bande passante d'un transformateur à entrefer, présentant une fréquence de coupure, **caractérisé en ce qu'**il comporte un filtre destiné à être relié en série avec le transformateur, et **en ce que** le filtre est adapté pour amplifier le signal qu'il reçoit du transformateur pour des fréquences inférieures à la fréquence de coupure du transformateur, de sorte que la bande passante du transformateur équipé du dispositif de correction est augmentée et présente une fréquence de coupure inférieure à celle du transformateur.

2. Dispositif de correction selon la revendication 1, **caractérisé en ce que** le filtre est un filtre du premier ordre dont la fréquence de coupure est égale à celle du transformateur.

3. Dispositif de correction selon la revendication 1, **caractérisé en ce que** le filtre est un filtre d'ordre supérieur ou égal à deux comportant une fréquence de coupure inférieure à celle du transformateur, adapté pour agir comme un filtre dérivateur pour des fréquences inférieures à la fréquence de coupure du filtre, comme un filtre intégrateur pour des fréquences comprises entre la fréquence de coupure du filtre et celle du transformateur et ayant un gain constant pour des fréquences supérieures à la fréquence de coupure du transformateur.

4. Dispositif de correction selon l'une quelconque des revendications 1 à 3, **caractérisé en ce qu'**il est implémenté de manière analogique.

5. Dispositif de correction selon l'une quelconque des revendications 1 à 3, **caractérisé en ce qu'**il est implémenté de manière numérique.

6. Transformateur à entrefer équipé d'un dispositif selon l'une quelconque des revendications 1 à 5.

7. Relais de protection équipé d'un dispositif selon l'une quelconque des revendications 1 à 5 et adapté pour être relié en aval d'un transformateur à entrefer.

8. Procédé de correction de la bande passante d'un transformateur à entrefer, présentant une fréquence de coupure, **caractérisé en ce qu'**il comporte des étapes de :

   - mesure (E1) de valeurs d'un signal de courant en sortie du transformateur à entrefer,
   - application (E2) d'un filtrage aux valeurs mesurées qui amplifie le signal de courant pour des fréquences inférieures à la fréquence de coupure du transformateur, de sorte que la bande passante du transformateur équipé du dispositif de correction est augmentée et présente une fréquence de coupure inférieure à celle du transformateur.

9. Programme d'ordinateur comportant des instructions pour l'exécution des étapes du procédé selon la revendication 8 lorsque ledit programme est exécuté par un ordinateur.

10. Support d'enregistrement lisible par un ordinateur sur lequel est enregistré un programme d'ordinateur comprenant des instructions pour l'exécution des étapes du procédé selon la revendication 8.

FIG. 1

FIG. 3

FIG. 2a

FIG. 2b

FIG. 4a

FIG. 4b

FIG. 4c

FIG. 5

1000    1001

10

1002    1003

# FIG. 6

E1

E2

E3

# FIG. 7

**EP 2 833 379 A1**

Europäisches Patentamt
European Patent Office
Office européen des brevets

# RAPPORT DE RECHERCHE EUROPEENNE

Numéro de la demande
EP 14 17 8868

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | RAY W F: "Rogowski transducers for high bandwidth high current measurement", 19941102, 2 novembre 1994 (1994-11-02), pages 10/1-10/6, XP006503545, * figures 1-5 * | 1-10 | INV.<br>H01F27/42<br>H03F3/45<br>H03H11/12<br>H04B3/14<br><br>ADD.<br>G01R15/18 |
| A | LU Q ET AL: "A DFT-BASED APPROACH FOR PRECISE TUNING OF A BAND-PASS FILTER FOR THE EXTRACTION OF CONTROL SIGNALS FROM POWER LINES", POWER ELECTRONICS AND MOTION CONTROL. SAN DIEGO, NOV. 9 - 13, 1992; [PROCEEDINGS OF THE INTERNATIONAL CONFERENCE ON INDUSTRIAL ELECTRONICS, CONTROL, INSTRUMENTATION AND AUTOMATION (IECON)], NEW YORK, IEEE, US, vol. 1 - 02 - 03, 9 novembre 1992 (1992-11-09), pages 530-535, XP000369006, DOI: 10.1109/IECON.1992.254501 ISBN: 978-0-7803-0582-3 * figure 1 * | 1-10 | |
| A | LAFSER J E ET AL: "A VERSATILE RC-ACTIVE CIRCUIT FOR INSTRUMENTATION", PROCEEDINGS OF THE MIDWEST SYMPOSIUM ON CIRCUITS AND SYSTEMS. CHAMPAIGN, AUG. 14 - 16, 1989; [PROCEEDINGS OF THE MIDWEST SYMPOSIUM ON CIRCUITS AND SYSTEMS], NEW YORK, IEEE, US, vol. SYMP. 32, 14 août 1989 (1989-08-14), pages 177-180, XP000139640, * figure 2 * | 1-10 | DOMAINES TECHNIQUES RECHERCHES (IPC)<br><br>G01R<br>H01F<br>H03F<br>H03H<br>H04B |
| A | FR 1 596 405 A (UNITED CONTROL CORP.) 15 juin 1970 (1970-06-15) * figures 1,2 * | 1-10 | |

Le présent rapport a été établi pour toutes les revendications

| Lieu de la recherche | Date d'achèvement de la recherche | Examinateur |
|---|---|---|
| La Haye | 26 août 2014 | Radomirescu, B-M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

15

**ANNEXE AU RAPPORT DE RECHERCHE EUROPEENNE
RELATIF A LA DEMANDE DE BREVET EUROPEEN NO.**

EP 14 17 8868

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-08-2014

| Document brevet cité<br>au rapport de recherche | Date de<br>publication | Membre(s) de la<br>famille de brevet(s) | | Date de<br>publication |
|---|---|---|---|---|
| FR 1596405        A | 15-06-1970 | CH | 494496  A | 31-07-1970 |
| | | DE | 1906602  A1 | 13-08-1970 |
| | | FR | 1596405  A | 15-06-1970 |
| | | GB | 1239069  A | 14-07-1971 |
| | | JP | S4947061  B1 | 13-12-1974 |
| | | SE | 365084  B | 11-03-1974 |
| | | US | 3564441  A | 16-02-1971 |

EPO FORM P0460